# FASCICULE DE BREVET EUROPEEN

(11) **EP 2 877 277 B1**
(45) Date de publication et mention de la délivrance du brevet: **14.10.2020**
(21) Numéro de dépôt: 13745450.0
(22) Date de dépôt: 04.07.2013
(51) Int. Cl.: B01J 13/00, B82Y 30/00, B82Y 40/00, C30B 29/46, C30B 28/04

(54) **PROCÉDÉ DE PREPARATION DE SOLUTION COLLOÏDALE DE PARTICULES AMORPHES**
VERFAHREN ZUR HERSTELLUNG EINER KOLLOIDALEN LÖSUNG AMORPHER PARTIKEL
PROCESS TO PREPARE COLLOIDAL SOLUTIONS OF AMORPHOUS PARTICLES

(30) Priorité: 26.07.2012 FR 1257242
(43) Date de publication de la demande: 03.06.2015
(73) Titulaire: IMRA EUROPE S.A., F-06560 Valbonne (FR)
(72) Inventeur: BOURDAIS, Stéphane, F-06600 Antibes (FR); CHONE, Christophe, F-06480 La Colle Sur Loup (FR); CUCCARO, Yan, F-06600 Antibes (FR)
(74) Mandataire: Cabinet Beau de Loménie
(86) Numéro de dépôt international: PCT/FR2013/051597
(87) Numéro de publication internationale: WO 2014/016489

(56) Documents cités:
- WO-A1-99/37832
- WO-A1-99/37832
- WO-A1-2011/066205
- WO-A1-2011/066205
- WO-A1-2014/118444
- WO-A2-2010/124212
- WO-A2-2010/124212
- US-A1- 2012 070 936

## Description

La présente divulgation concerne un procédé de fabrication de film ou couche mince continue de chalcogénure métallique cristallisée à gros grains déposée sur un substrat.

Plus particulièrement la présente divulgation concerne un dispositif photovoltaïque solide comprenant un film ou une dite couche de chalcogénure métallique à titre de couche d'absorption.

Plus particulièrement encore une couche de chalcogénure métallique selon l'invention sera utilisée comme couche d'absorption dans un dispositif photovoltaïque solide, notamment du type substrat ou de type superstrat comprenant au moins :
- une couche conductrice optiquement transparente dite de contact avant, par exemple de type TCO (oxyde transparent conducteur), et
- une couche de composé isolant et transparent, par exemple une couche de ZnO ou ZnMgₓO₁₋ₓ, et
- une couche tampon de semi-conducteur de type n, par exemple de CdS ou In₂S₃ ou Zn(S,O,OH), et
- une dite couche d'absorption de type p, et
- une couche de matériau conducteur dite de contact arrière, par exemple une couche de métal molybdène (Mo), or (Au), graphite (C), Nickel (Ni) ou encore d'aluminium (Al), argent (Ag) ou indium (In).

Dans un dispositif photovoltaïque solide dit de type substrat, les couches ci-dessus sont complétées par :
- une grille métallique appliquée contre ladite couche de contact avant, constituant ainsi la face avant (côté soleil) du dispositif, et
- une couche de verre ou acier appliquée contre ladite couche de contact arrière.

Dans un dispositif photovoltaïque solide dit de type superstrat, les couches ci-dessus sont complétées par une couche de verre constituant la face avant (côté soleil) du dispositif, appliquée contre ladite couche de contact avant.

Des dispositifs photovoltaïques solides à structure de type substrat ou de type superstrat sont bien connus de l'Homme de l'art. Ils sont par exemple décrits dans la préface du livre « Thin film solar cells ; fabrication, characterization and applications, édité par Jef Poortmans et Vladimir Arkhipov, Wiley 2007, ISBN 13 9780470 09126-5, préface page xxiv).

La présente invention concerne un procédé de préparation d'une solution aqueuse colloïdale de nanoparticules amorphes de chalcogénure métallique selon la revendication 1, la solution colloïdale obtenue et son utilisation pour la fabrication d'un film de chalcogénure(s) métallique(s) à gros grains.

Dans la présente description, on entend par « solution colloïdale » ou « colloïde », un liquide de dispersion homogène de particules dont les dimensions vont de 2 à 500nm, étant entendu qu'en dessous de 2 nm on obtient une solution liquide et non pas une dite « solution colloïdale ». La stabilité d'une telle dispersion homogène est due à la lenteur de la séparation des 2 phases solide et respectivement liquide.

On entend par « matériau constitué de nanoparticules amorphes », un matériau ne contenant pas ou peu de particule cristallisée, c'est-à-dire se caractérisant par l'absence de pic de diffraction par diffraction de rayons X (technique XRD).

Plus particulièrement encore, la présente invention concerne des chalcogénures métalliques de formule M-C dans laquelle :
- M présente un ou plusieurs éléments métalliques identiques ou différents choisis parmi Cu, Zn, Sn, Ge, Sb et Bi, de préférence Cu, Zn, Sn et Sb, et
- C représente un ou plusieurs éléments chalcogénures identiques ou différents choisis parmi S, Se et Te.

Les plus hauts rendements de conversion photovoltaïque à base de chalcogénures métalliques sont supérieurs à 20% ; ils sont aujourd'hui obtenus avec des cellules photovoltaïques comprenant comme couche d'absorption de type CuIn₁₋ₓ,GaₓSe₂.

Toutefois, l'indium (In) et le gallium (Ga) sont trop peu abondants sur terre et donc trop chers pour une production de masse. Le tellure de cadmium CdTe est un autre exemple bien connu parmi les chalcogénures métalliques qui permet d'obtenir des dispositifs photovoltaïques à rendement élevé (>17%). Mais, la relative faible abondance du cadmium et du tellure, ainsi que la toxicité du Cd constituent un problème.

Les composés chalcogénures métalliques M-C tel que définis ci-dessus sont particulièrement intéressants pour la fabrication de couche d'absorption d'un dispositif photovoltaïque à bas coût et à relativement haut rendement car les métaux M listés ci-dessus sont abondants et non toxiques.

La présente divulgation concerne plus particulièrement des couches d'absorption du type Cu₂ZnSnS₄ (CZTS) ainsi que leurs dérivés Cu₂Zn(Sn_{1-y},Ge_{y})(S₁₋ₓ,Seₓ)₄ (noté CZTGSSe), SnS, Sb₂S₃ et Cu₂Zn(Sn_{1-y},Sb_{y})(S₁₋ₓ,Seₓ)₄ et ou CuSb(S,Se)₂

Les couches de chalcogénure métallique pour cellules photovoltaïques sont obtenues traditionnellement par des procédés de dépôt sous vide comme la co-évaporation (CIGSe), la sublimation en espace fermé (CdTe) ou encore la pulvérisation cathodique (CZTSSe). Cependant les coûts de production et de maintenance associés aux techniques de vide sont typiquement élevés, ce qui limite leur utilisation dans des applications pour des marchés de masse. De même, les procédés de dépôt chimique en phase gazeuse font appel aux techniques de vide, ce qui les rend compliqués et coûteux pour réaliser le dépôt de façon continue et sur de larges surfaces.

Pour contourner ces limitations, des procédés de dépôt à pression ambiante sont donc préférables, comme par exemple le dépôt en bain chimique, le dépôt électrochimique, la pulvérisation (spray), l'impression ou le coulage en bande. Le dépôt en bain chimique se caractérise généralement par de faibles vitesses de dépôt par rapport à l'épaisseur souhaitable pour la couche active (de l'ordre du micromètre), des compromis entre faible rendement chimique et uniformités d'épaisseurs (a fortiori sur de grandes surfaces) et la formation de matériau de faible qualité cristalline (ce qui nécessite un recuit postérieur) avec l'inclusion d'impuretés plus ou moins contrôlées ce qui rend la technique inappropriée pour la fabrication de la couche active photovoltaïque. De façon analogue, le dépôt électrochimique ne permet pas non plus de dépôt en continu et pose des problèmes de contrôle d'uniformité sur de grandes surfaces, ce qui impose des vitesses de dépôts relativement lentes.

Il est donc préférable de réaliser le dépôt de la couche photovoltaïque active par un procédé de dépôt à base d'une solution déposée par exemple par pulvérisation ou par impression, ou d'une pâte déposée par exemple par coulage en bande. Dans tous les cas, ces techniques de dépôts à pression atmosphérique, potentiellement en continu et sur de grandes surfaces sont à base d'une solution liquide ou colloïdale plus ou moins concentrée.

Par rapport à une solution liquide, la solution colloïdale présente certains avantages. Dans une solution liquide, les espèces utiles (cuivre, étain, soufre, etc.) sont dissoutes dans le solvant, par exemple sous forme ionique (exemple Cu+) ou de complexes ioniques (exemple Cu(CH₃CN)₄⁺, Cu(NH₃)n]²⁺, Sn(OH)₆]²⁻ etc.). Dans une solution colloïdale, aussi appelée « colloïde », des particules solides sont présentes en suspension et composées des espèces chimiques utiles; la taille de ces particules est inférieure au millimètre et typiquement de l'ordre de quelques dizaines de nanomètres.

Par comparaison avec la solution liquide, un premier intérêt de la solution colloïdale est de pouvoir séparer la partie solide utile c'est-à-dire les particules, de la partie liquide (par filtration ou sédimentation/centrifugation) et ainsi de pouvoir rincer le colloïde de ses impuretés et des éventuels produits secondaires, résidus de réactions chimiques ayant pu servir à fabriquer le colloïde. Un deuxième intérêt est que les espèces chimiques utiles sont déjà rassemblées de façon solide à l'échelle atomique avec une stœchiométrie/composition chimique égale ou proche de la composition finale souhaitée, ce qui assure un meilleur contrôle de la composition finale, par rapport à une solution liquide qui peut aisément être mal mélangée. Un troisième intérêt de la solution colloïdale est qu'on peut l'utiliser comme solution de départ pour former une couche dense par différents procédés, les nanoparticules pouvant être séchées et frittées pour réaliser un matériau plus ou moins poreux (pour servir ensuite à diverses applications, comme des électrodes pour piles, pour catalyse, etc. ou bien redispersées dans un liquide de dispersion permettant le dépôt par pulvérisation ou par coulage en bande sur un substrat. En outre, il est également possible de déposer les particules sur et à l'intérieur d'un substrat nano-poreux pour en modifier les propriétés de surface. C'est le cas par exemple de films nano-poreux de TiO₂ nanocristallin (semi-conducteur n) d'un dispositif photovoltaïque, par exemple en trempant un substrat de TiO₂ nano poreux dans une dite solution colloïdale de chalcogénure métallique.

Les meilleures performances photovoltaïques de cellules à base de films CZTSSe sont obtenues lorsque le film est fabriqué par un procédé par voie hybride entre liquide et colloïde (Todorov & al. : Thin solid Films Vol. 519, N° 21 (2011) pp 7378-81). Cependant le solvant hydrazine utilisé par cette équipe est à la fois très hautement toxique et très inflammable à l'air, ce qui nécessite des précautions d'emploi incompatibles avec un usage industriel. Afin de réduire le risque d'inflammabilité, l'hydrazine a aussi été diluée jusqu'à 50% en ajoutant de l'eau, ce qui a eu pour conséquence de réduire légèrement la performance de 9.6% à 8.2%. Malgré tout, la toxicité et les précautions d'emploi liées à l'hydrazine persistent.

Un autre procédé relativement bien documenté dans la littérature est le procédé dit « par injection de précurseurs à chaud » (WO2008/021604A2). Ce procédé consiste à réaliser une réaction chimique, pendant plusieurs heures et à température élevée (entre 220°C et 300°C) entre des précurseurs métalliques (sels sous forme de poudres) dissous dans un solvant oleylamine ou autres solvants également toxiques ou dangereux pour l'homme et/ou l'environnement de type alkylamine ou alkyl phosphine (TOPO), et d'y injecter à chaud une solution contenant le chalcogène. Par exemple du soufre métallique, du sélénium ou un sel à base de soufre est typiquement dissout dans de l'oxyde de TriOctylPhOsphine (TOPO). L'oxyde de TriOctylPhOsphine est extrêmement destructeur des tissus des muqueuses, des voies respiratoires supérieures, des yeux et de la peau. Dans un procédé alternatif, (brevet chinois CN102108540) d'injection à chaud (180-280°C pendant 2-60min), le solvant organique octadécylamine servant à dissoudre le soufre en poudre, est un solvant inflammable, explosif et extrêmement dangereux pour les yeux, la peau, et les milieux aquatiques. C'est pourquoi plus particulièrement la présente invention concerne un procédé de préparation de solution colloïdale de chalcogénure métallique.

Il est généralement admis par l'homme de l'art que de faibles performances photovoltaïques sont obtenues lorsque la couche active d'absorbeur du dispositif photovoltaïque, à base de semi-conducteurs cristallins inorganiques tels que le silicium, les semi-conducteurs III-V (AsGa, AIGaAs etc.) ou de chalcogénures métalliques CdTe, CIGS ou CZTS, est composée de petits grains, et que de meilleures cellules photovoltaïques sont réalisées à partir de couches continues à gros grains. Typiquement les tailles de grains souhaitées sont alors de l'ordre de l'épaisseur de la couche, elle-même de l'ordre du micromètre.

D'autre part, on peut remarquer que dans leur immense majorité, les procédés de synthèse colloïdale visent à fabriquer des particules cristallisées. Les arguments avancés sont en général une plus grande pureté, ou bien l'obtention d'une couche moins poreuse, ou bien encore un meilleur contrôle de la composition élémentaire des particules à l'échelle atomique (avant même de former la couche) et par conséquent de celle de la couche finale. Enfin, la couche cristalline finale qui est visée serait plus facilement obtenue à partir de particules cristallines, car incorporant déjà la phase cristalline souhaitée. Cependant ces procédés de fabrication de solution colloïdale de particules de chalcogénure métallique cristallisées requiert l'ajout de ligands, la croissance cristalline étant alors activée thermiquement à 200°C ou davantage, ce qui représente des procédés longs et couteux. De plus les films réalisés à partir de ces solutions colloïdales de nanoparticules cristallines de chalcogénure métallique doivent néanmoins être ensuite soumis généralement à un traitement thermique additionnel à des températures plus élevées, de l'ordre de 400 à 600°C, ceci afin de densifier, agglomérer et augmenter la taille des cristaux, de préférence jusqu'à une taille de grains voisine de l'épaisseur totale du film, typiquement de l'ordre du micromètre. Il serait avantageux au moins au plan économique (moindre budget thermique) de réaliser la synthèse colloïdale des particules sans besoin de chauffer pendant la synthèse à 200°C.

Les premiers travaux de synthèse colloïdale, en présence d'eau, ont rapidement mis en évidence des problèmes d'hydrolyse et/ou oxydation des espèces ioniques métalliques notamment les cations Cu⁺, Zn2⁺, Sn4⁺, Sb3⁺, In3⁺.

Une technique connue de l'homme de l'art pour réduire efficacement les problèmes d'hydrolyse et d'oxydation en milieu aqueux consiste à protéger une espèce ionique en solution par un ligand.

Dans WO2011/066205 et WO2011/146791, on décrit un procédé de synthèse de solution colloïdale de nanoparticules de chalcogénure de cuivre cristallines dans lequel on met en œuvre des solutions de précurseurs de métal et de chalcogène avec des ligands, en milieu acide pour ajuster le pH et éviter l'hydrolyse et/ou l'oxydation des espèces ioniques métalliques. On entend ici par « ligand », un coordinat constitué d'un ion ou molécule portant des fonctions chimiques lui permettant de se lier à un ou plusieurs atomes ou ions centraux métalliques par liaison covalente. Dans WO2011/066205, les nanoparticules de chalcogénure de cuivre sont produites à partir d'un mélange réactionnel des solutions de précurseur par agitation pendant plusieurs heures et optionnellement par chauffage à 100°C et au-delà. Dans WO2011/146791, on évite la mise en œuvre d'eau et de solution aqueuse colloïdale pour éviter des problèmes d'hydrolyse et/ou d'oxydation des espèces ioniques métalliques notamment des cations Cu⁺, Zn2⁺, Sn4⁺, Sb3⁺. Dans ces 2 brevets WO2011/146791 et WO2011/066205, le rôle des ligands est aussi d'éviter l'agglomération des nanoparticules formées, agglomération qui mène à la précipitation et donc à l'instabilité du colloïde. Il a été montré que la mise en œuvre de ligands organiques nuit aux propriétés de transport électrique entre les particules.

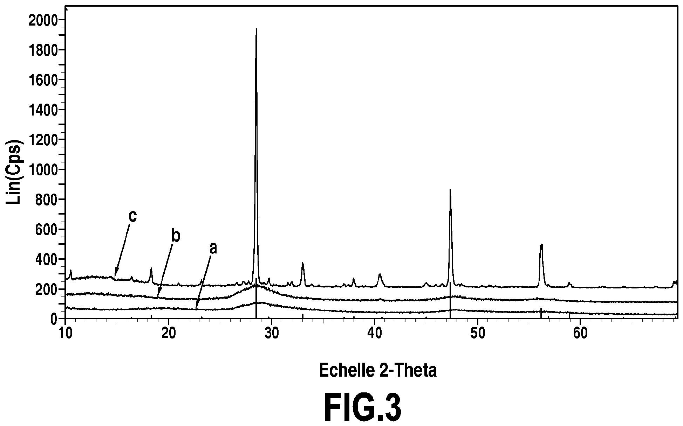

Dans WO2011/0662205, les ligands sont des molécules organiques comprenant des groupes amine, thiol ou d'acide organique. Ces ligands organiques visent à complexer ledit métal pour ralentir la cinétique de réaction entre les précurseur métallique et précurseur de chalcogénure en vue d'obtenir une solution colloïdale de nanoparticules cristallisées comme le montre la figure 3 (et non pas une solution colloïdale de nanoparticules amorphes conformément à la présente invention). Les solutions colloïdales obtenues sont peu stables et, la présence de ligands dans lesdites solutions colloïdales obtenues rend le procédé moins aisé (nécessité de chauffer), plus long et plus coûteux et, de surcroît dans le film de chalcogénure cristallisé obtenu après dépôt et recuit de la solution colloïdale sur un substrat, les résidus carbonés ou oxydes issus de la décomposition des ligands est un inconvénient car ils peuvent empêcher la cristallisation et/ou limiter la formation de gros grains et/ou générer des impuretés créant des défauts électriques, ce qui nuit aux propriétés photovoltaïques du film.

Dans WO 2011/0662205, l'acétonitrile n'est pas cité comme ligand et ne correspond pas à la définition donnée d'un ligand, mais il est cité comme solvant de formulation de la solution colloïdale après sa préparation.

Dans les publications Schulz & al. 1997/2000 (Photovoltaics Program Review édité par AIP Press, New York 1997, WO99/37832) et Zhang & al. 2012 (Applied Physics Express 5, 2012, 012301), on décrit des procédés de préparation de solution colloïdale de chalcogénures métalliques constituées de nanoparticules amorphes ou faiblement cristallisées pour la réalisation de film d'absorbeur semi-conducteur de dispositif photovoltaïque. Dans ces 2 publications, on réalise la solution colloïdale de chalcogénure métallique à partir d'un mélange d'une première solution de précurseur dudit métal M et d'une deuxième solution de précurseur dudit chalcogène. Dans Schulz et al. ci-dessus, on prépare plus particulièrement une solution colloïdale de chalcogénure métallique CuInGaSe₂ (CIGS) et dans Zhang & al. ci-dessus, on prépare un chalcogénure métallique de Cu₂ZnSn(S,Se)₄ (CZTSSe) à partir de solution de précurseur dans des solvants organiques pyridine et méthanol. Plus particulièrement, dans ce procédé, il s'agit typiquement de dissoudre des sels précurseurs métalliques à savoir des iodures tels que CuI, CdI₂, ZnI₂, SnI₄, InI₃, GaI₃, dans la pyridine, et d'autre part de dissoudre un sel précurseur chalcogénure (de sodium ou de potassium tel que Na₂Te, Na₂Se, ou Na₂S) dans le méthanol. Ces deux solutions sont ensuite mélangées à -78°C ou -42°C ou encore -0°C selon les cas publiés (et non par injection à chaud comme c'est le cas usuel dans les procédés de synthèse colloïdale de nanoparticules cristallisées), par introduction de la solution soufre/méthanol dans la solution métaux/pyridine, puis le mélange est ramené à température ambiante pendant plusieurs minutes au cours desquelles le colloïde instable précipite naturellement.

Les solutions colloïdales initiales (avant formation d'une couche mince) étaient donc des solutions non aqueuses colloïdales de nanoparticules non cristallisées (amorphes) ou faiblement cristallisées.

Dans les conditions mises en œuvre dans ces publications, il est proposé que l'eau cause la déstabilisation, l'agrégation et la décomposition du colloïde par échange ionique des méthanol ou acetonitrile par l'eau qui s'accroche en surface des particules, ce qui ensuite introduirait de l'oxygène dans les couches déposées et dégraderait leur performance photovoltaïque.

Dans les références Schulz & al. 1997/2000 et Zhang & al. 2012 ci-dessus, la synthèse de solution colloïdale de nanoparticules amorphes par mélange de solution de précurseurs est réalisée à froid (-178°C, -42°C ou 0°C) ce qui représente une contrainte et un coût et oblige d'utiliser des solvants organiques compatibles avec ces températures, mais relativement toxiques, notamment le méthanol et/ou la pyridine.

Ces conditions de température semblent imposées par la nécessité de stabiliser le colloïde de chalcogénure métallique concerné dans les solvants concernés. En outre dans les références Schulz & al. 1997/2000 et Zhang & al. 2012 ci-dessus, les films en couche mince déposés sur substrat obtenus par dépôt à partir de ces solutions colloïdales composées de particules amorphes ou faiblement cristallisées sont caractérisés par des petites tailles de grains, même après recuit à température élevée, ce qui ne permet pas d'obtenir des performances photovoltaïques de haute qualité. En particulier dans WO99/37832 (Schulz & al.), la couche de CIGS à petits grains obtenue après dépôt par pulvérisation présente une trop grande porosité et n'a pas pu être densifiée malgré les traitements thermiques variés. En effet, malgré de nombreuses tentatives de recuit, les films CIGS obtenus comportaient toujours une couche intermédiaire constitués de petits grains, ce qui ne correspond pas aux critères d'une couche de haute qualité pour application photovoltaïque. En effet, la faible performance photovoltaïque de la cellule CIGS était attribuée à la résistance série élevée de cette couche intermédiaire, poreuse et à petits grains.

Un désavantage du procédé décrit dans Schulz & al 1997/2000 ci-dessus à partir de nanoparticules amorphes issues de mélange méthanol/pyridine, est donc qu'il ne permet pas de réaliser une couche dense de CIGS à gros grains, qui sont nécessaires à la réalisation de dispositif photovoltaïque à haut rendement.

Dans Zhang & al. 2012 ci-dessus, le film obtenu par dépose de la solution colloïdale de nanoparticules de chalcogénure métallique comprenait des nanoparticules de relativement grandes tailles (80 nm) et après recuit sur un substrat ne présentait pas de gros grains. D'autre part, dans Zhang & al. 2012, les auteurs n'ont pas réussi à obtenir une solution colloïdale lorsque le chalcogénure métallique comprenait uniquement du soufre et non pas une combinaison de soufre S et sélénium Se. Dans Zhang & al. 2012 ci-dessus, la solution de méthanol comprenant à la fois Na₂S et Na₂Se, a conduit à la formation de colloïde solide fortement agrégé et amorphe, dans lequel les auteurs distinguent des particules arrondies de taille 80nm de CZTSSe (Cu₂ZnSn(S,Se)₄). Après dépôt sur molybdène puis recuit de densification, un résultat photovoltaïque négligeable (0.0002%) a été obtenu lorsque le recuit 550°C est réalisé sous azote seul, en raison d'une décomposition cristalline du film (d'après analyses XRD). Un résultat photovoltaïque de 2.2% a été obtenu lorsque le recuit 550°C est réalisé sous azote avec ajout d'étain, ce qui éviterait la décomposition. Hormis un spectre de diffraction X prouvant la présence de cristaux de CZTSSe après l'étape de traitement thermique à haute température (550°C), aucune indication de la taille de grains du film n'est donnée.

Un premier but de la présente invention est donc de fournir un nouveau procédé de préparation de solution colloïdale de nanoparticules de chalcogénure métallique qui soit rapide et économique à réaliser, notamment un procédé qui permette la préparation de solution colloïdale à température ambiante ne nécessitant pas de chauffer pendant des heures à 100°c et au-delà et ne nécessitant pas de refroidir à 0°C ou en deçà.

Un autre but de la présente invention est donc de fournir un procédé permettant de préparer des solutions colloïdales de chalcogénure métallique de formule M-C défini ci-dessus, n'impliquant pas la mise en œuvre de solvants toxiques ou nécessitant des températures de réaction à froid, en particulier à une température inférieure ou égale à 0°C.

Un autre but est de fournir un procédé de fabrication de film obtenu à partir d'une solution colloïdale qui permet d'obtenir des cristaux de chalcogénure métallique à gros grains, ledit film étant déposé sur un substrat utile pour conférer de hautes performances photovoltaïques à un dispositif photovoltaïque en comprenant.

Plus particulièrement, un but de la présente invention est donc de fournir un procédé de préparation de solution colloïdale de chalcogénure métallique de formule M-C défini ci-dessus qui soit réalisé à température ambiante et pression atmosphérique n'impliquant pas la mise en œuvre de solvant dangereux et/ou toxique ni la mise en œuvre de ligand à liaison covalente tel que défini ci-dessus et/ou sans ajout d'acide dans des solutions de précurseurs lors de la préparation des solutions colloïdales.

Enfin, un but de la présente invention est de fournir une solution colloïdale stable de nanoparticules amorphes de chalcogénure métallique qui permette d'être déposée à pression atmosphérique et température ambiante puis densifiée par recuit sur un substrat pour obtenir un film de chalcogénure métallique cristallisé sous forme de gros grains avec un état de surface de faible rugosité.

Selon la présente invention, on a découvert que pour la préparation de solution colloïdale de chalcogénure métallique de formule M-C tel que défini ci-dessus, il est possible de travailler en milieu aqueux sans décomposition du colloïde moyennant les conditions de mise en œuvre du procédé de préparation d'une solution aqueuse ou hydro alcoolique colloïdale définies ci-après et permettant de mettre en œuvre un procédé de fabrication de film de nanoparticules de chalcogénure métallique semi-conducteur cristallisées à gros grains tel que défini ci-après également.

Pour ce faire, la présente invention fournit un procédé de préparation quasi instantané et à température ambiante, d'une solution aqueuse, alcoolique ou hydro alcoolique colloïdale de nanoparticules amorphes de chalcogénure(s) métallique(s) de formule M-C dans laquelle :
- M présente un ou plusieurs premiers métaux identiques ou différents choisis parmi Cu, Zn, Sn, Ge, Sb et Bi, de préférence Cu, Zn, Sn et Sb et
- C représente un ou plusieurs éléments chalcogénures identiques ou différents choisis parmi S, Se et Te,
caractérisé en ce qu'on réalise les étapes successives suivantes à température de 0° à 50°C, de préférence de 20° à 40°C dans lesquelles :
a) on réalise une première solution d'au moins un précurseur de dit premier métal M, autre qu'un sel de chalcogénure C en solution dans un solvant consistant dans de l'acétonitrile pur ou en mélange avec de l'eau et/ou un alcool autre que le méthanol, de préférence de l'éthanol, et
b) on réalise une deuxième solution aqueuse, alcoolique ou hydro alcoolique d'un moins un précurseur de chalcogénure de deuxième métal, autre qu'un premier métal M, l'alcool de ladite deuxième solution étant autre que le méthanol, de préférence de l'éthanol, et
c) on mélange à pression atmosphérique et température ambiante les 2 dites première et deuxième solutions de précurseurs jusqu'à obtenir dans un laps de temps inférieur à une minute une solution colloïdale brute comprenant des nanoparticules amorphes primaires de tailles inférieures à 30 nm, de préférence 3 à 20 nm, et
d) on sépare la partie solide de ladite solution colloïdale de l'étape c), de préférence par centrifugation pour obtenir un résidu solide après retrait du surnageant liquide, et
e) on rince le résidu solide obtenu à l'étape d) en y versant une solution aqueuse, alcoolique ou hydro alcoolique pour former une solution colloïdale, l'alcool de ladite solution colloïdale aqueuse, alcoolique ou hydro alcoolique étant autre que le méthanol, de préférence de l'éthanol, et
f) on sépare à nouveau la partie solide de ladite solution colloïdale de l'étape e), de préférence par centrifugation pour obtenir après retrait du surnageant liquide, un résidu solide rincé sous forme de pâte humide, et
g) on redisperse ladite pâte humide de l'étape f) dans un solvant de dispersion comprenant, de préférence consistant dans une solution aqueuse, alcoolique ou hydro alcoolique, l'alcool de ladite solution alcoolique ou hydro alcoolique étant, le cas échéant, un alcool autre que le méthanol.

Selon la présente invention, dans le procédé de préparation de la solution colloïdale, on réalise donc la préparation préalable à température ambiante ou nécessitant un chauffage réduit de deux solutions séparées de précurseurs à base de sels de M et respectivement sel de C avec des solvants différents, sans ajout de ligand, notamment aux étapes a) et b), et leur mélange à température réduite notamment à température ambiante et pression atmosphérique tel que défini aux étapes a) à c).

La plus petite taille des nanoparticules primaires obtenues à l'étape c) rend les étapes de rinçage d) à g) plus efficace pour enlever les produits secondaires de la réaction ainsi que le solvant de synthèse acétonitrile et autres impuretés résiduelles.

On entend ici par « ligand », une molécule organique (autre que la molécule C) apte à se lier et/ou à complexer un dit premier métal M, notamment une molécule organique substituée par au moins un groupe choisi parmi les groupes amine (-NH₂), thiol (-SH), amide ou thioamide, notamment -CONH₂ ou -CSNH₂, et/ou des groupes d'acide organique (tels que le groupe acide carboxylique -COOH ou un groupe acide phosphorique, notamment -PO₃H₂.

Une solution colloïdale stable à température ambiante obtenue sans ajout de ligand est non seulement plus facile à obtenir et à mettre en œuvre, mais, en outre, elle comprend moins d'impuretés résiduelles, ce qui contribue à améliorer la qualité d'un film obtenu après dépôt et recuit de la solution colloïdale comme décrit ci-après. En particulier, ceci contribue à obtenir un film continu cristallisé à gros grains et plus homogène avec de meilleures performances photovoltaïques.

De préférence, à l'étape g) on met en œuvre un solvant de dispersion consistant dans une solution aqueuse, alcoolique ou hydro alcoolique, l'alcool de ladite solution alcoolique ou hydro alcoolique étant un alcool autre que le méthanol présentant une température d'ébullition inférieure à la température d'ébullition de l'eau, de préférence de l'éthanol ou propanol, de préférence encore consistant en un mélange eau/éthanol.

Ces solvants de dispersion ont été sélectionnés pour leur propriété de dispersion des nanoparticules amorphes (concentration, stabilité du colloïde, viscosité, non toxicité), permettant de former un colloïde liquide, homogène et stable avec des nanoparticules amorphes de petites tailles, qui ne précipitent pas naturellement à température ambiante avant au moins 24 heures, et peuvent être déposées par pulvérisation (viscosité, pression de vapeur et température d'évaporation) dans des conditions optimales afin d'obtenir un film continu, homogène et sans impuretés tel que décrit ci-après.

Un alcool présentant un point d'ébullition inférieur à celui de l'eau est avantageux car dans un procédé de fabrication de film obtenu par dépôt, par pulvérisation et recuit de la solution colloïdale sur un substrat tel que décrit ci-après, lors du contact de la solution colloïdale sur la plaque chaude du substrat, il y a évaporation des solvants et, il apparait préférable que l'alcool s'évapore avant l'eau pour écarter les risques de contamination résiduel en carbone provenant dudit alcool au sein dudit film.

L'éthanol et le propanol sont préférés du fait de leur miscibilité totale dans l'eau, outre leur température d'ébullition inférieure à celle de l'eau (et pression de vapeur supérieure à celle de l'eau).

On définit la température ambiante utilisée pour la préparation des solutions ainsi que lors du mélange des étapes a) à c) comme étant une température comprise entre 0°C et 50°C, de préférence de 20 à 40°C.

Ce procédé de préparation de solution colloïdale selon l'invention est donc particulièrement avantageux en ce que :
- il est réalisé à température réduite notamment à température ambiante et pression atmosphérique,
- il est quasi instantané et fournit un colloïde homogène et stable, et
- il permet la mise en œuvre de solvant aqueux en l'absence de solvant toxique et/ou de ligand organique à liaison covalente et sans ajout d'acide, et
- le pH s'autocontrôle à pH acide inférieur à 2, sans ajustement de Ph, du fait des solvants et précurseurs mis en œuvre, et
- l'acétonitrile n'est pas un solvant dangereux ou toxique et permet de protéger les atomes des cations métalliques contre l'oxydation jouant ainsi le rôle de ligand protecteur contre l'hydrolyse des précurseurs et/ou des particules formées, sans être engagé dans une liaison covalente contrairement à un ligand.

La rapidité de la réaction à l'étape c), réalisée dans un laps de temps inférieur à une minute, même inférieur à 5 secondes, est la conséquence de l'absence de ligand complexant et liant ledit métal.

Cette rapidité de réaction des précurseurs à l'étape c), contribue à obtenir des nanoparticules amorphes et de plus petites tailles, les nanoparticules n'ayant pas le temps de grandir les unes au dépend des autres.

D'autre part, les concentrations élevées et petites tailles de nanoparticules confèrent une plus grande stabilité du colloïde de nanoparticules obtenues à l'étape c), celles-ci restant stable au moins deux jours à température ambiante.

La solution colloïdale obtenue permet en outre d'obtenir un film de chalcogénure(s) métallique(s) cristallin(s) à gros grains après dépôt et recuit d'une couche de nanoparticules de chalcogénure(s) métallique(s) amorphes sur un substrat.

Un autre avantage de l'emploi pendant la synthèse colloïdale, de solvant aqueux, alcoolique ou hydro alcoolique selon l'invention tient en ce que ils permettent de dissoudre plus facilement les sels précurseurs de chalcogénure c'est-à-dire dans de plus fortes concentrations notamment une concentration supérieure à 5 M (moles par litre) dans les cas des sels NaSH ou Na₂S. Les colloïdes obtenus peuvent ainsi être davantage concentrés. De la même façon, les sous-produits de réaction sont plus facilement dissous et éliminés à l'aide d'un nombre d'étapes de rinçage moindre avec des solvants de rinçage aqueux ou hydro alcoolique.

Selon d'autres caractéristiques plus particulières préférées :
- à l'étape a), ledit sel dedit premier métal M est un halogénure, de préférence un chlorure, et
- à l'étape b), ledit chalcogénure dedit deuxième métal (autre que M) est un sel alcalin ou alcalino-terreux, de préférence un sel de sodium ou potassium, de préférence Na₂S ou NaSH.

Dans les publications antérieures, le sel d'halogénure métallique ou précurseur de métal M était souvent sous forme d'iodure, l'iodure se dissolvant mieux que le chlorure dans les solvants organiques mis en œuvre. La mise en œuvre de précurseurs chlorures selon la présente invention notamment en milieu aqueux ou hydro alcoolique est toutefois avantageuse car les sels chlorures sont plus faciles d'accès (et moins couteux) et le colloïde CZTS qui en résulte est plus stable qu'avec les précurseurs iodures.

De préférence encore, M est un mélange ternaire de Cu, Zn et Sn, et C est S, et de préférence à l'étape c) on obtient des nanoparticules amorphes de Cu₂ZnSnS₄.

La mise en œuvre d'un chalcogénure métallique contenant uniquement le chalcogène S sans sélénium (Se) est avantageux car le sélénium réduit la bande interdite de la couche d'absorption et une fois mise en œuvre dans un dispositif photovoltaïque, le chalcogénure métallique avec uniquement S permet d'obtenir des tensions photovoltaïques supérieures (au-delà de 0.6 Volts d'après la littérature.)

Dans un autre mode de réalisation M-C est choisi parmi Sb₂S₃ et SnS.

Dans d'autres modes de réalisation encore M-C est choisi parmi CuSbS₂, Cu₂Sn(S,Se)₃, Cu₂Zn(Sn,Sb)S₄, Cu₃BiS₃ et Cu₄SnS₄.

Selon d'autres caractéristiques particulières avantageuses :
- à l'étape a) on réalise une dite première solution contenant CuCl₂, ZnCl₂ et SnCl₄, et
- à l'étape b), on réalise une dite deuxième solution aqueuse de NaSH, de préférence à une concentration supérieure à 5 M, et
- à l'étape c), on obtient des nanoparticules amorphes de Cu₂ZnSnS₄, notamment de taille 3 à 20 nm.

Un autre effet avantageux de la mise en œuvre de sel hydro-sulfure de chalcogénure tel que NaSH ou KSH est que leur réaction avec les chlorures métalliques renforce le caractère acide des solutions colloïdales ainsi obtenues, ce qui réduit les risques de dégradation des nanoparticules par une éventuelle hydrolyse par les ions OH⁻. L'ajustement de pH, par une étape supplémentaire consistant par exemple à ajouter un acide, est ainsi inutile et le procédé est plus aisé et donc avantageux.

Selon d'autres caractéristiques particulières :
- à l'étape b), ladite deuxième solution aqueuse de précurseur(s) de chalcogénure(s) consiste en une solution contenant uniquement de l'eau comme solvant ; et
- à l'étape a), le solvant de ladite première solution de précurseur(s) de métal(aux) M consiste en de l'acétonitrile en mélange avec de l'eau, de préférence dans un rapport volumique acétonitrile/eau d'au moins 50/50, de préférence de l'acétonitrile pur ; et
- on réitère une ou plusieurs fois, les étapes f) et g) de rinçage du colloïde, par centrifugation puis redispersion dans un solvant aqueux, alcoolique ou hydro-alcoolique ; et
- l'eau et les solvants utilisés sont préalablement désoxygénés par barbotage/bullage avec un gaz ne contenant pas d'oxygène, de préférence un gaz neutre, de préférence encore de l'azote, et le mélange de l'étape c) se fait dans une enceinte sous vide ou contenant une atmosphère sans oxygène, de préférence de gaz neutre, de préférence encore d'azote. Cette dernière caractéristique permet d'éviter l'oxydation et/ou l'hydrolyse des cations métalliques dans les solutions précurseurs et dans la solution colloïdale.

Dans la présente demande, on entend par « atmosphère sans oxygène », une teneur en oxygène inférieure à 1 ppm (partie par million).

La présente divulgation fournit également une solution colloïdale, ou encre formulée dans un solvant dit de dispersion comprenant une solution aqueuse, alcoolique ou hydro alcoolique, obtenue par le procédé de préparation d'une solution colloïdale selon l'invention, de nanoparticules amorphes comprenant des nanoparticules primaires de tailles inférieures à 30 nm, de préférence 3 à 20 nm, l'alcool de ladite solution étant un alcool non toxique notamment autre que le méthanol.

Plus particulièrement, ladite solution colloïdale consiste en desdites nanoparticules en dispersion dans un solvant de dispersion consistant dans une solution aqueuse, alcoolique ou hydro alcoolique de nanoparticules amorphes, ledit alcool de ladite solution présentant une température d'ébullition inférieure à celle de l'eau, de préférence ledit solvant de dispersion consistant de préférence en un mélange eau/éthanol.

Plus particulièrement encore, ladite solution colloïdale ne contient pas de ligands organiques tels que définis ci-dessus. On entend ici par « nanoparticules primaires », des nanoparticules telles qu'obtenues avant leur agrégation ultérieure éventuelle sous forme d'agrégat de plus grande taille de plusieurs nanoparticules primaires entre elles.

L'obtention de nanoparticules primaires de plus petites tailles dispersées dans les solvants aqueux et/ou alcooliques de la présente invention est avantageux pour obtenir non seulement, dans un premier temps un colloïde stable sans ajout de ligand mais aussi dans un second temps un film homogène à gros grains cristallisés sans impuretés résiduelles de ligands organiques dans le procédé de fabrication décrit ci-après.

La présente divulgation fournit un procédé de fabrication d'un film de chalcogénure(s) métallique(s) polycristallin à gros grains cristallins de tailles au moins égales à la moitié de l'épaisseur dudit film, à l'aide d'une solution colloïdale obtenue selon la présente invention, ledit film étant déposé sur un (ou des) matériau(x) en couche(s) formant un substrat, ledit chalcogénure métallique étant de formule M-C dans laquelle :
- M présente un ou plusieurs éléments métalliques identiques ou différents choisis parmi Cu, Zn, Sn, Ge, Sb et Bi, de préférence Cu, Zn, Sn et Sb, et
- C représente un ou plusieurs éléments chalcogénures identiques ou différents choisis parmi S, Se et Te,
dans lequel on réalise les étapes successives suivantes :
1) on dépose sur ledit substrat, une couche de nanoparticules amorphes de chalcogénure(s) métallique(s) à partir d'une dite solution colloïdale aqueuse, alcoolique ou hydro alcoolique obtenue selon l'invention, et
2) on réalise un traitement thermique de ladite couche de chalcogénure(s) métallique(s) à une température d'au moins 300°C de préférence au moins 450°C, pour obtenir une densification de ladite couche de chalcogénure(s) métallique(s) et une cristallisation des nanoparticules, sur une épaisseur de 0,2 à 5 µm, de préférence d'environ 1 µm.

Dans les exemples 3 et 4 ci-après on montre que le solvant de dispersion préférentiel est un mélange eau-éthanol pour réaliser après dépôt par pulvérisation et traitement thermique, un film de couches CZTS cristallines à gros grain, continues et dense (sans craquelure ni trou) et adhérentes sur un substrat de molybdène.

Plus particulièrement, dans le procédé de fabrication d'un film :
- à l'étape 1), on pulvérise une dite solution aqueuse colloïdale avec un gaz porteur constitué d'un gaz sans oxygène de préférence un gaz neutre, de préférence encore de l'azote, à pression atmosphérique et à une température de substrat porté à au moins 100°C, pour former sur un dit substrat, une couche de ladite solution colloïdale d'épaisseur de 0,5 à 15 µm de préférence d'environ 3 µm, et,
- les étapes 1) et 2) sont réalisées dans une enceinte sous vide ou remplie d'un gaz dépourvu d'oxygène, de préférence un gaz neutre, de préférence encore de l'azote.

Avantageusement, ledit substrat est un substrat destiné à être recouvert d'une couche d'absorption de semi-conducteur de type p dans un dispositif photovoltaïque solide.

Plus particulièrement, ledit substrat est constitué d'une couche de verre ou d'acier recouvert d'une couche dite de contact arrière, de préférence constituée d'une couche de molybdène, utile dans un dispositif photovoltaïque solide de type substrat.

Plus particulièrement encore, ledit substrat est un substrat destiné à être recouvert d'une couche d'absorption dans un dispositif photovoltaïque de type superstrat, ledit substrat étant constitué d'une couche de verre recouverte d'au moins successivement :
- une couche conductrice transparente de contact avant, et
- de préférence une couche de composé isolant et transparent, et
- une couche tampon de semi-conducteur de type n.

Ladite couche tampon de semi-conducteur de type n constitue alors une jonction p-n avec ladite couche d'absorption de type p, ladite couche tampon étant par exemple constituée de CdS, In₂S₃, ou Zn(S,O,OH).

La présente divulgation fournit également un film de chalcogénure(s) métallique(s) cristallisé(s) à gros grains cristallins de taille au moins égale à la moitié de l'épaisseur dudit film, déposé continûment sur un substrat obtenu par le procédé de fabrication de film.

Plus particulièrement, le film présente une rugosité de surface avec une hauteur moyenne arithmétique des pics Sa, selon la norme ISO 25178, inférieure à la moitié de l'épaisseur e du film, de préférence inférieure à 0,2 x e, de préférence encore inférieure à 0,15 x e pour une surface d'au moins 20x20 µm².

Cette propriété de faible rugosité de surface du film obtenu par le procédé est originale et avantageuse en ce qu'elle évite le contact direct entre les deux couches adjacentes du film. Cette propriété de continuité de la couche est avantageuse pour éviter les court-circuits électriques du dispositif photovoltaïque.

Plus particulièrement encore, le film est constitué de chalcogénure(s) métallique(s) Cu₂ZnSnS₄ (CZTS) sous forme cristalline de Kesterite, d'épaisseur de 0,1 à 5 µm, de préférence environ 1µm.

Pour déterminer si une couche mince d'une solution colloïdale séchée est cristallisée ou amorphe, on met donc en œuvre la technique de diffraction de rayon X, (voir par exemple l'ouvrage de René Guinebretière, 2^{ème} édition Lavoisier, Paris, ISBN 2-7462-1238-2).

La taille d'une particule est mesurée par microscopie électronique, soit par microscopie électronique à balayage (MEB), soit par microscopie électronique à transmission (MET).

La technique de diffraction de rayons X (par exemple en mode ϑ-2ϑ) permet aussi de mesurer la taille d'un cristallite, à partir de la largeur intégrée des pics de diffraction. Il faut pour cela que le matériau présente des raies de diffraction (qu'il soit cristallin) mais aussi que les cristallites soient suffisamment petits, de l'ordre de 50 nanomètres ou inférieur à 100 nanomètres. Au-delà, la technique est inappropriée en raison des limites physiques des équipements DXR.

Pour déterminer la taille d'une nanoparticule amorphe/faiblement cristallisée à l'échelle de quelques dizaines de nanomètres, on privilégie donc la microscopie électronique, en transmission (MET) (par exemple voir l'ouvrage Transmission Electron Microscopy, Volumes I, II, III et IV d'après Williams et Carter, éditions Springer 1996, ISBN 978-0-306-45324-3).

La morphologie d'un film cristallin se caractérise par les dimensions de ses reliefs en particulier la taille de ses grains et sa rugosité, que l'on observe par microscopie (microscopie optique, microscopie à force atomique, microscopie électronique MEB ou TEM, etc.)

Dans le cas des films cristallisés à gros grains, la technique de choix pour mesurer des tailles de grains de l'ordre du micromètre est alors le microscope électronique à balayage (MEB) (voir par exemple l'ouvrage « Microscopie Electronique à Balayage et Microanalyses, Ed. Brisset, EDP Science 2008, ISBN 978-7598-0082-7).

La mesure de la rugosité de surface d'un film a été réalisée avec un microscope à force atomique (AFM) et microscope à sonde locale (SPM), de modèle AFM/SPM de Agilent Tech. (U.S.A.), série 5100.

La présente divulgation fournit également un dispositif photovoltaïque comprenant une couche d'absorption constituée d'un dit film déposé sur un substrat.

Plus particulièrement, le dispositif photovoltaïque comprend les couches suivantes successivement empilées :
- un substrat, de préférence du verre sodo-calcique, recouvert d'une fine couche conductrice de molybdène servant de couche de contact électrique arrière,
- une dite couche mince de matériau absorbeur, de préférence constituée essentiellement de CZTS,
- une couche tampon, de préférence une couche faite à base de semi-conducteur de type n, comme le sulfure de cadmium CdS, ou le sulfure d'indium In₂S₃, ou encore des alliages oxysulfures tels que Zn(S,O,OH),
- une couche transparente conductrice, de préférence une couche composée d'une première couche de ZnO dite intrinsèque (non-dopée), recouverte d'une couche conductrice transparente, de préférence d'oxyde d'indium dopé étain (ITO en anglais) ou oxyde de zinc dopé aluminium (AZO, en anglais), et
- une grille métallique (d'Aluminium, nickel, et/ou argent) de contact électrique face avant déposée sur ladite couche transparente.

D'autres caractéristiques et avantages apparaîtront à la lumière des exemples détaillés de réalisation qui vont suivre en référence aux figures suivantes.

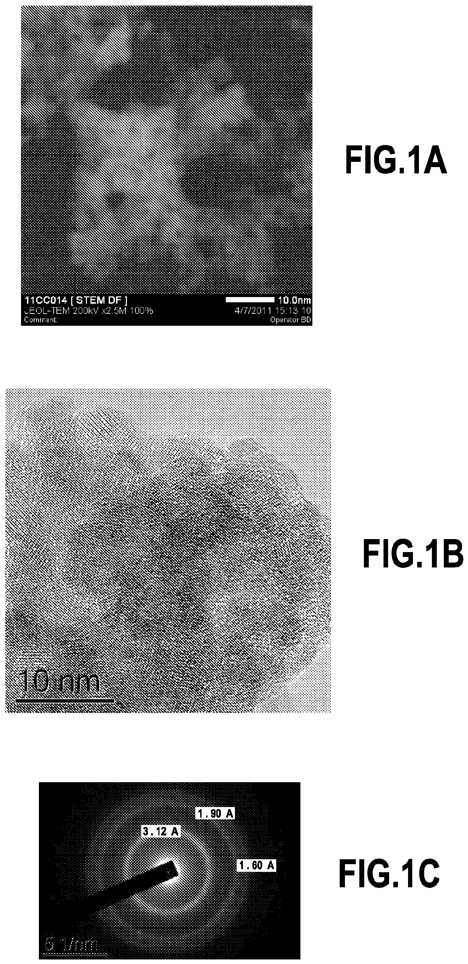

Les figures 1A et 1B représentent des photographies en observation par MET de colloïde brut de CZTS préparé dans un mélange eau/acétonitrile selon l'exemple 1, par mesure avec détecteur STEM (figure 1A) et à plus fort grossissement MET (figure 1B), la figure 1C étant une photographie de spectre de diffraction obtenu par diffraction d'électron ED de la poudre séchée.

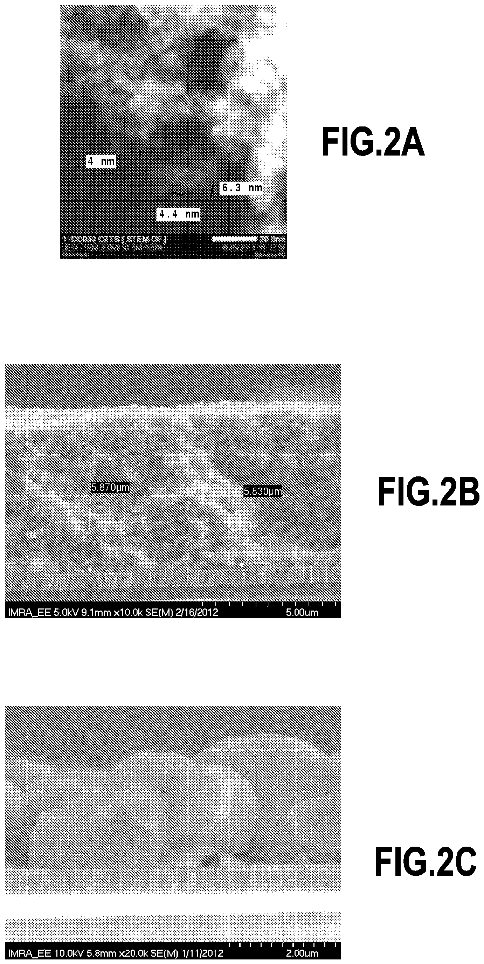

Les figures 2A, 2B et 2C représentent des photographies par microscopie de type MEB de nanoparticules CZTS sous forme colloïdale (figure 2A), et après dépôt sous forme d'un film déposé par pulvérisation sur un substrat (figure 2B), et après recuit à 525°C dudit film (figure 2C).

Ces photographies sont prises par microscopie électronique mesurée à différentes étapes de la fabrication du film, sur un substrat de verre recouvert de molybdène (Figure 2B et 2C).

La figure 3 est un spectre de diffraction de rayons X mesuré sur des couches de nanoparticules des figures 2A (courbe a), 2B (courbe b) et 2C (courbe c). Les valeurs Cps («Coups par seconde ») en ordonnées sont en échelle linéaire (« Lin »).

Les figures 4 A) à 4 D) représentent des photographies prises par microscopie électronique, après recuit de cristallisation à 525°C, de la surface d'un film CZTS selon l'exemple 4 dispersé dans un solvant éthanol pur et dépôt par pulvérisation à 75°C (Fig.4A), un solvant TEP et pulvérisation à 300°C (Fig.4B), un solvant DMSO et pulvérisation à 300°C (Fig.4C) et un solvant eau et pulvérisation à 300°C (Fig.4D).

La figure 5 représente une courbe caractéristique courant-tension sous simulateur solaire (100mW/cm²) d'une cellule photovoltaïque Cu₂ZnSnS₄ en structure substrat Mo selon l'exemple 7 (surface active = 0.25 cm²).

### Exemple 1 : Préparation d'un colloïde de CZTS

Un colloïde de nanoparticules Cu-Zn-Sn-S a été fabriqué en faisant réagir un mélange de sels métalliques de CuCl, ZnCl₂, SnCl₄:5H₂O dans l'eau/acétonitrile avec une solution aqueuse de NaSH, à température ambiante et sous ambiance inerte d'azote, selon la réaction globale :

2CuCl + ZnCl₂ + SnCl₄ + 4NaSH ⇔ Cu₂ZnSnS₄ + 4NaCl + 4HCl

Ce système réactif est adapté en ce sens que les sous-produits de réaction, par exemple NaCl ou HCl, sont solubles dans l'eau tandis que les nanoparticules sont solides, et dispersées sous forme de colloïde.

La solution aqueuse (0,12 M) de NaSH est préparée dans une bouteille de 50 ml, par pesée de 0,56 grammes de poudre NaSH hydraté (fournisseur Aldrich, produit 16,152,7) et ajout de 50mL d'eau dés ionisée préalablement désoxygénée par bullage pendant 30minutes par de l'azote. Cette solution aqueuse de précurseur soufre NaSH est ensuite scellée par un bouchon, puis stockée.

La solution de chlorures métalliques de cuivre-zinc-étain (CZT) dans l'eau/acétonitrile est préparée en boîte à gants azote par :
1. pesée de 469 mg de poudre de précurseur cuivre : CuCI (fournisseur Aldrich 224332), 415mg de poudre de précurseur zinc : ZnCl₂ (fournisseur Aldrich 208086) et 893 mg de poudre de précurseur étain : SnCI4 hydraté (Aldrich 244678) ; puis
2. par ajout de 10 ml d'acétonitrile anhydre (Aldrich 271004) ;
3. après dissolution et mélange par ultrasons pendant quelques minutes, on obtient une solution jaune-verdâtre de concentration 1 Mol/L (Cu+Zn+Sn) qui est ensuite diluée 5 fois dans l'acétonitrile (volumes dans un rapport de 1 à 4) puis elle même diluée 2 fois avec de l'eau (volumes 1 et 1) et ainsi obtenir une concentration de 0,1 Mol/L.

La réaction de synthèse colloïdale est réalisée en versant 10 ml de la solution (0,12 M) NaSH dans 10 ml de solution de précurseurs métalliques (0,1 M) CZT. Cette synthèse effectuée à pression et température ambiantes est très rapide et donne lieu à une solution colloïdale CZTS, selon la réaction globale indiquée plus haut.

Le pH de ce colloïde brut a été mesuré égal à pH=0,3 ce qui définit un caractère acide très fortement marqué, favorable pour éviter l'hydrolyse des éléments métalliques ou des particules.

Ce colloïde brut a été analysé par Microscopie Electronique à Transmission. On utilise un modèle 2100 FEG 200kV de la société JEOL (Japon), équipé de détecteurs EDX (Energy-dispersive X-ray Spectroscopy), STEM BF (Scanning Transmission Electron Microscope Bright Field) et STEM DF (Surface Transmission Electron Microscope Dark Field) à grand angle HAADF (High Angular Annular Dark Field).

Pour cela, un porte échantillon constitué d'une membrane de carbone sur une grille de nickel a été trempé dans le colloïde non dilué puis simplement séché à l'air ambiant avant d'être introduit dans la chambre sous vide du MET. D'après la figure 1A, le colloïde séché forme des agrégats de nanoparticles primaires dont la taille caractéristique est 2 à 5 nm et avec une forme arrondie caractéristique de particules amorphes. L'analyse élémentaire moyenne réalisée par mesure EDX sur de nombreuses zones, indique que ces particules séchées contiennent les éléments majoritaires Cu, Zn, Sn, S, et Cl comme impureté. A plus fort grossissement MET (Figure 1B), c'est à dire en concentrant le faisceau d'électrons incidents, certains plans cristallins semblent être observables, attribuables à une probable cristallisation sous faisceau, pendant l'observation MET. Les analyses de diffraction d'électrons, comme illustré par l'exemple de la Figure 1C, montrent la présence d'anneau de diffraction diffus, correspondant à des plans de diffraction atomique caractérisés par des distances interatomiques compatibles avec la structure cristalline connue de kesterite Cu₂ZnSnS₄ (CZTS). Le colloïde brut observé sous MET apparaît donc amorphe ou faiblement cristallisé dans la structure probable kesterite (en particulier avec cristallisation pendant l'observation MET à fort grossissement).

L'analyse de la composition (MET EDX) est la suivante :

| Cu | Zn | Sn | S | Ni | Cl | at.% |
|---|---|---|---|---|---|---|
| 24.2 | 15.7 | 10.4 | 47.4 | 0.0 | 2.3 | 100 |

Ce colloïde brut est ensuite versé dans un tube à centrifugation puis centrifugé 5 min à 6000 tr/min (centrifugeuse Universal 16 de la société Hettich Zentrifugen AG), soit une accélération de 3700 G exprimée par rapport à la gravité. Ceci permet de séparer les parties solide et liquide. La partie liquide supérieure transparente (le surnageant) est retirée en la versant dans une bouteille de déchets liquides acides. La partie solide inférieure est alors rincée par l'ajout de 20 ml d'eau. Après introduction d'un barreau magnétique recouvert de téflon, cette solution a été placée sur une plaque magnétique et mélangée par agitation magnétique à environ 200tr/min pendant 5 minutes. Une nouvelle centrifugation de 10 min à 9000 tr/min (soit 8400 G) est réalisée, suivie du retrait du surnageant. Cette procédure de rinçage vise à éliminer les produits de réactions tels que NaCl, HCl et autres espèces ioniques en excès. Nous avons mesuré que la partie résiduelle solide inférieure et humide forme une pâte qui est composée d"environ 100 mg de matière sèche (CZTS) et de 500 mg de liquide, par pesée avant et après séchage sous vide.

On a re-dispersé ensuite cette pâte dans un mélange d'eau/éthanol (5mL /5mL), puis mélangé par agitation magnétique pendant 5 minutes à température ambiante ; Le colloïde obtenu est alors stable pendant quelques jours et peut être utilisé pour un dépôt par pulvérisation/atomisation « spray ».

Les particules en suspension dans ce colloïde rincé ont été analysées par microscopie MET (Figure2A) en utilisant la même procédure avec membrane de carbone sur grille de nickel, comme décrit auparavant pour la mesure MET du colloïde brut (Figure1A). La microscopie avec détecteur STEM DF de la Figure2A montre des nanoparticules primaires de forme arrondie, agglomérées et de taille analogue entre 2 et 7 nm typiquement. L'analyse EDX (non montrée) indique la présence majoritaire des éléments Cu, Zn, Sn et S mais l'absence d'élément chlore, ce qui illustre l'effet du rinçage. L'analyse MET haute résolution et la diffraction d'électron étant sujet à caution en raison de la cristallisation sous faisceau d'électrons, les caractéristiques cristallographiques ont été mesurées par diffraction X sur la pâte issue du colloïde brut rincé (mais non re-dispersé), étalée grossièrement sur une plaque de verre 2.5x2.5 cm² à température ambiante.

Les mesures de diffraction X ont été réalisées dans un diffractomètre de type Bruker AXS D8 série 2, utilisant une source de rayons X correspondant à la raie d'émission Kα du cuivre, en mode rasant (avec un angle d'incidence fixé à 1°) et un détecteur mobile sur un arc de cercle pour obtenir un spectre d'angle de diffraction 2ϑ balayé de 10° à 70° avec un pas de 0,04°.

La courbe a de la Figure 3 (spectre inférieur) montre le spectre de diffraction de rayons X de la pâte humide de la Figure 2A. Ce spectre ne présente pas de pics de diffraction très bien définis mais plutôt deux bosses très larges, dont les positions en 2ϑ= 28.4° et 2ϑ= 47.3° peuvent correspondre à celles des deux pics principaux (112) et (220)/(204) respectivement, de la structure cristalline kesterite de spectres de références de diffraction de rayons X mesurés sur des matériaux cristallins sous forme de poudre. Ainsi les particules composant le colloïde rincé puis séché à l'air ambiant, sont majoritairement amorphes ou faiblement cristallisées, en accord avec les observations MET des Figures 1A et 1B (colloïde brut) ou observations MET de la Figure 2A (colloïde rincé et reconditionné ou redispersé).

Les nanoparticules solides du colloïde brut et du colloïde rincé puis redispersé sont toutes deux caractérisées par une taille nanométrique (2-7nm), composées des éléments Cu, Zn, Sn et S, de structure cristalline amorphe voire très faiblement cristallisées.

### Exemple 2 : Préparation d'un colloïde brut de CZTS concentré

La concentration du colloïde CZTS notée en mol par litre (ou M), est définie comme le nombre de molécules du composé CZTS (Cu₂ZnSnS₄ ou de façon équivalente le nombre d'atomes d'étain) par unité de volume. Dans l'exemple 1 ci-dessus, la concentration du colloïde brut est de 0.0125 M. Dans le présent exemple, la concentration du colloïde CZTS a été portée à 0.25 M, qui équivaut à environ 100 mg/ml. L'homme de l'art reconnaîtra là une valeur correspondant à la concentration typique d'une pâte légèrement diluée, que l'on peut déposer par coulage en bande. Cela illustre la versatilité de la méthode de synthèse colloïdale.

Dans cette variante, une solution aqueuse (6M) de NaSH est préparée, par pesée de 2.24g pour 4ml de solution. Une solution de chlorures métalliques de cuivre-zinc-étain (CZT) dans l'acétonitrile est préparée par pesée de 188mg de CuCl, 166mg de ZnCl₂ et 357mg de SnCl₄ hydraté pour 5ml de solution. La synthèse est réalisée en versant dans un premier temps 11ml d'eau désionisée et désoxygénée dans la solution de précurseurs métalliques, puis dans un deuxième temps les 4ml de solution NaSH.

Le colloïde brut du composé CZTS ainsi fabriqué est concentré (0.25M) et, de plus, présente une forte stabilité après l'addition d'eau à l'étape de rinçage indiquée dans l'exemple 1 ci-dessus.

### Exemple 3 : Préparation d'un film de CZTS cristallisé sur substrat de verre recouvert de molybdène.

On distingue ci-après et de manière conventionnelle la composition du film cristallisé Cu₂ZnSnS₄ et la composition du film amorphe déposé par spray avant recuit écrite sous forme Cu-Zn-Sn-S.

Des couches amorphes de Cu-Zn-Sn-S ont été déposées à partir de nanoparticules en suspension, par pulvérisation (« spray ») sur des substrats de type Mo/verre formés de verre sodo-calcique d'épaisseur 1 mm recouverts d'une couche de molybdène de 700nm.

Dans le présent exemple de dépôt par pulvérisation, on a préparé un colloïde conformément à l'exemple 1 ci-dessus, puis re-dispersé le colloïde dans un mélange d'eau/éthanol (5mL /5mL).

L'étape de pulvérisation a été réalisée dans une boite à gants (modèle GP concept type T3 en acier inox, société Jacomex S.A.S., France) remplie d'azote et équipée d'une unité de purification (<1ppm O₂, <10ppm H₂O) et d'un sas servant à l'entrée/sortie d'échantillons. Les films amorphes Cu-Zn-Sn-S ont été déposés sur des substrats Mo/verre (2,5cm x 2,5 cm) portés à une température de 250°C à l'aide d'une plaque chauffante (modèle 18x18cm céramique standard, référence 444-0617 de la société VWR International SAS, France) avec une régulation thermique modifiée en boucle fermée sur un thermocouple de type K placé sous le substrat. Un robot cartésien X-Y a été utilisé (de type Yamaha, FXYx 550x550 avec contrôleur RCX222, distribué en France par la société New-Mat France pour balayer une surface de plus de 16 cm² par la buse de spray utilisée (flacon pulvérisateurs sur éprouvette en verre borosilicate de la société Glasskeller Basel AG). Pour l'injection de la solution colloïdale dans la buse, l'application d'une pression d'azote a été contrôlée de façon intermittente : ouvert 0.3 seconde puis attente 1,7 seconde ; ce cyclage de 2 secondes étant maintenu pendant la durée de pulvérisation. De bons films ont été obtenus avec une distance buse-substrat d'environ 15 cm avec un flux moyen de gaz porteur azote de 14 L/min à une pression de bouteille azote de 0.2 bar. Des épaisseurs de 6 ± 1 µm ont été obtenues en déposant par spray pendant deux minutes du colloïde de concentration 10 mg/ml (soit un volume d'environ 2 ml).

La morphologie des couches amorphes Cu-Zn-Sn-S ainsi déposées a été déterminée par Microscopie Electronique à Balayage MEB (Hitachi Ltd, modèle S-4700 équipé d'analyseur EDX et traitement de données par logiciel NORAN). La figure 2B est une vue de section d'un film Cu-Zn-Sn-S déposé par pulvérisation à 240°C. Sur cette image on peut voir le substrat verre recouvert d'une couche de 700 nm de molybdène poly cristallin à structure colonnaire, et le film Cu-Zn-Sn-S. On peut déceler que ce film est poreux et composé de fines particules agglomérées ensemble et séparées par du vide.

La nature amorphe / faiblement cristallisée des films obtenus par dépôt pulvérisation à partir des colloïdes CZTS, a été mise en évidence par mesure de diffraction de rayons X, comme indiqué par le spectre de la Figure 3 (courbe b médiane). Là encore, aucun pic de diffraction n'est clairement décelable.

L'étape de recuit servant à la densification et cristallisation de la couche pour former de gros grains cristallins a été réalisée sous boite à gants azote (référence GT concept, de la société Jacomex SAS, France). Le film déposé par pulvérisation a ensuite été posé sur une plaque chauffante (modèle plaque Titane avec boitier de contrôle Detlef, société Harry Gestigkeit, GmbH) et chauffé sous azote progressivement jusqu'à à une température de recuit de 525°C maintenue pendant 1 heure, puis refroidie pendant 1 heure. La Figure 2C montre une vue de section du film obtenu après recuit : au-dessus de la couche polycristalline molybdène, un film polycristallin d'une épaisseur de 1.8 ± 0.2 µm traduit la densification du film qui est accompagnée d'une cristallisation avec formation de larges grains souhaités (de 1 à 2 µm) c'est-à-dire voisine de l'épaisseur du film.

L'état de surface du film ci-dessus a été analysé et sa rugosité Sa a été mesurée selon la norme ISO 25178. La rugosité moyenne Sa est définie comme la moyenne arithmétique des valeurs absolues des ordonnées du profil de rugosité. Les valeurs suivantes ont été obtenues pour un film d'épaisseur de 1,8 µm : 313 nm pour une surface de 50x50µm², 247 nm pour une surface de 20x20µm².

### Exemple 4 : Préparation d'un film de CZTS cristallisé sur substrat de verre recouvert de molybdène à partir d'une encre CZTS formulée dans des solvants de dispersion purs.

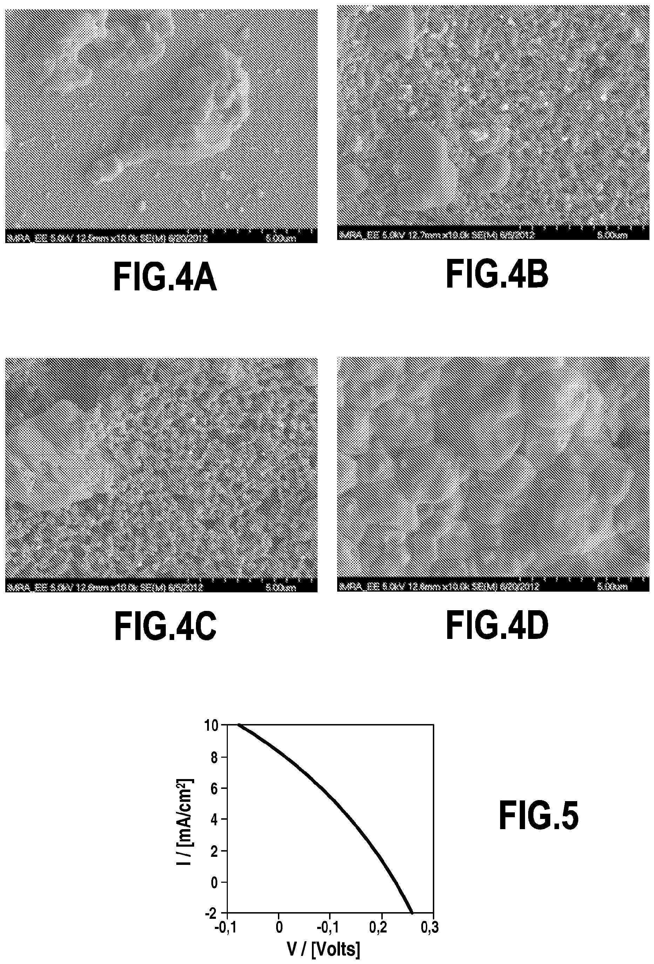

Dans le présent exemple, on a préparé un colloïde CZTS conformément à l'exemple 1, à ceci près que de la pâte rincée à l'eau puis centrifugée a ensuite été mélangée dans des solvants de dispersion différents du mélange eau-éthanol 50-50 de l'exemple 3. Parmi ceux-ci, quatre ont été sélectionnés pour le présent exemple notamment pour leurs pressions de vapeur à 20°C faible pour le TEP (Tri-Ethyl-Phosphate) (40 Pa) ou le DMSO (80 Pa) ou bien élevée pour l'eau (2330 Pa) et l'éthanol (5850 Pa) La concentration a été ajustée à 10 g/L. Après dépôt par spray en boîte à gants conformément à l'invention, les échantillons CZTS/Mo/verre obtenus ont ensuite été soumis à un traitement thermique de cristallisation à 525°C sous azote. Les images de surface des échantillons obtenus sont montrées sur les Fig. 4A à 4D.

Ce film CZTS sont formés de grains CZTS cristallisés comme l'indiquent les spectres de diffraction X, (non montrés). Cependant, dans les cas A) éthanol, B) Tri-Ethyl-Phosphate (TEP) ou C) Di-Méthyl-Sulf-Oxide (DMSO), l'adhésion au substrat n'est pas suffisante, le taux de recouvrement du substrat n'est pas complet, et la taille de grains n'est pas homogène. Seul le solvant eau (Fig. 4-cas D) permet d'obtenir à la fois un taux de recouvrement élevé du film CZTS à gros grains cristallins et avec bonne adhésion sur le substrat Molybdène/verre.

Le présent exemple montre que l'eau est le solvant pur de dispersion préférentiel. Les exemples 3 et 4 montrent que le solvant de dispersion est préférentiellement un mélange eau-éthanol, qui est un solvant abondant, facile à utiliser et non toxique et qui permet de réaliser après dépôt par pulvérisation (spray) puis traitement thermique de cristallisation, des couches CZTS cristallines à gros grains, continues et dense (sans cracks ni trous) et adhérentes sur le substrat de molybdène.

### Exemple 5 : Préparation d'un colloïde de Sb₂S₃.

Une solution précurseur de soufre est d'abord préparée en mélangeant 18ml d'acétonitrile et 2 ml d'eau à température ambiante, puis en y versant 18 mg de poudre de NaSH (0,321 mmol) qui se dissout spontanément. Comme le NaSH n'est pas ou peu soluble dans l'acétonitrile, la dissolution a lieu dans la partie aqueuse du mélange eau/acétonitrile.

Une solution de précurseur métallique d'antimoine de concentration 10,7 mol/Litre est ensuite préparée par dissolution de 4 mg (0,214 mmol) de poudre SbCl₃ (Aldrich) dans une solution de 20mL d'acétonitrile pur. Aucune hydrolyse du sel SbCl₃ n'est remarquée durant cette dissolution.

En versant la solution de précurseur de soufre dans la solution métallique à température ambiante, une coloration orange est immédiatement observée, caractéristique de la phase solide Sb₂S₃ amorphe, résultant de la formation spontanée et en quelques secondes, d'un colloïde stable. Ce colloïde est difficile à centrifuger, ce qui témoigne de la grande stabilité du colloïde, ce qu'on relie à la faible taille/masse des nanoparticules primaires en suspension. En effet une analyse par microscopie en transmission (MET) est ensuite conduite : une grille de cuivre avec membrane carbone est trempée quelques secondes dans le liquide colloïdal pour en collecter une faible partie, puis laissée à sécher à l'air ambiant. L'observation sous MET indique des petites particules primaires agglomérées dont la taille individuelle est d'environ 20 nanomètres. L'analyse élémentaire MET +EDX montre une composition majoritairement Sb₂S₃ ainsi que la présence d'impuretés chlorées (de l'ordre de 1 % atomique). Aucune phase cristalline n'est identifiable par diffraction d'électrons sous faisceau d'électrons MET, ce qui indique que les particules solides du colloïde sont constituées de sulfure d'antimoine Sb₂S₃ amorphe. La synthèse colloïdale par mélange des deux solutions antimoine/acétonitrile et soufre/eau a ainsi été réalisée selon la réaction globale : 2SbCl₃ + 3 NaSH <=> Sb₂S₃ + 3NaCl + 3HCl.

En utilisant deux solutions soufre et métallique préparées dans des conditions identiques à l'exemple ci-dessus, on a inversé l'ordre du mélange en versant la solution métallique dans la solution soufrée. Là aussi, une coloration orange a été immédiatement observée avec la formation spontanée de colloïde Sb₂S₃ amorphe et de couleur orange caractéristique.

### Exemple 6 : préparation de colloïde SnS

Une solution métallique d'étain 0,05M est préparée dans une bouteille de verre de contenance 50mL, dans laquelle on verse d'abord 348 mg de poudre de précurseur d'étain (SnCl₂ anhydre, Fluka 96529) puis 36 ml de solvant acétonitrile. La dissolution est facilitée à température ambiante par ultrasonication pendant quelques minutes.

Comme dans les exemples ci-dessus, une solution aqueuse 0,2M soufrée est préparée par pesée de 1,12 g de poudre de NaSH, puis par ajout de 100 ml d'eau pure désionisée et désoxygénée pour réaliser leur dissolution spontanée.

La synthèse colloïdale est ensuite réalisée par mélange à température ambiante des deux solutions, par exemple en versant 9 ml de la solution 0,2M soufrée dans 36 ml de solution métallique d'étain 0,05M. Un colloïde noir se forme alors spontanément selon la réaction globale : SnCl2 + NaSH <=> SnS + NaCl + HCl. Ce colloïde est stable dans les conditions ambiantes pendant plusieurs jours. L'observation MET de ce colloïde ainsi fabriqué et sans autre traitement (sans rinçage, centrifugation, redispersion etc.) est présentée ci-après. En particulier, l'analyse élémentaire MET - EDX indique que la composition est majoritairement du sulfure d'étain, avec présence d'impureté chlore, qui est une impureté résiduelle de la réaction selon la composition suivante (MET EDX):

| Sn | S | Cl | C | N | O | at.% |
|---|---|---|---|---|---|---|
| 45.2 | 52.3 | 2.5 | 0.0 | 0.0 | 0.0 | 100 |

Les particules primaires formées sont relativement petites, avec une taille caractéristique de l'ordre de 3 à 5 nm. Ce colloïde peut alors être utilisé pour être rincé puis reformulé sous forme d'une pâte ou d'une encre pouvant servir au dépôt de couches minces.

### Exemple 7 : Dispositif photovoltaïque du type couche mince réalisé avec une couche de CZTS recuite dans une atmosphère d'azote.

On a préparé une couche mince de CZTS sur un substrat de verre recouvert de molybdène, recuite sous atmosphère N₂, comme dans l'Exemple 3.

Sur la couche CZTS continue cristallisée à gros grains, on a déposé une couche tampon de CdS de 50 nm approximativement, par dépôt en bain chimique selon la procédure usuelle de l'état de l'art (voir par exemple G. Hodes, Chemical Solution Deposition Of Semiconductor Films, ISBN 08247-0851-2, M. Dekker Inc.), par trempe dans un mélange maintenu à 60°C d'eau désionisée, d'ammoniac (NH₃, 4M), de nitrate de cadmium (Cd(NO₃)₂, 4mM) et de thio-urée (SC(NH₂)₂, 0.2M). Après 10minutes, les échantillons ont été rincés dans l'eau désionisée puis séchés sous flux d'azote.

Sur cette couche tampon on a déposé successivement deux couches optiquement transparentes par pulvérisation cathodique magnétron en utilisant un appareil commercial H2 d'Intercovamex: Une première couche isolante d'environ 50nm de ZnO [135W RF, 0.5Pa d'argon] suivie d'une couche transparente conductrice d'environ 250nm d'oxyde d'indium dopé 10% massique d'étain (ITO, en anglais) [70W RF, 0.25 Pa d'argon]. La résistance carrée de la couche ITO obtenue est approximativement de 30 ohms par carré.

Ensuite, le substrat a été divisé en 16 cellules électriquement isolées, chacune de dimensions carrées 0,5 cm x 0,5 cm. Afin de collecter le courant et mesurer la performance photovoltaïque, un contact face avant a été réalisé par un petit point de 0.5 mm d'argent déposé par séchage d'une laque chargée en argent, sur la couche conductrice ITO. Le contact arrière a été pris directement sur le Molybdène, au bord du substrat.

Le rendement photovoltaïque (ou efficacité photovoltaïque) a été calculé à partir des caractéristiques électriques courant-tension de la diode photovoltaïque mesurées sous irradiation lumineuse. Le rendement de conversion est le pourcentage de la puissance électrique délivrée par le dispositif au point de puissance maximum, par rapport à la puissance de la radiation incidente : η= (puissance électrique au point de puissance maximum)/(puissance de la radiation incidente). Cette efficacité photovoltaïque a été mesurée avec un banc de test électrique et qui utilise un simulateur solaire délivrant une irradiation de 1000 W/m² correspondant à la norme AM1.5G. Le banc de mesure a été calibré selon la procédure standard sur la base du photo-courant connu de cellules de référence, telles que fournies par différents instituts officiels reconnus.

Comme l'illustre la Figure 5, les rendements préliminaires tels que décrits dans cet exemple, ont été de l'ordre de 1%, les courants à court-circuit ont été aux alentours de 8 mA/cm² et les tensions à circuit ouvert aux alentours de V_{co} = 0,25V.

## Revendications

1. Procédé de préparation d'une solution aqueuse, alcoolique ou hydro alcoolique colloïdale de nanoparticules amorphes de chalcogénure(s) métallique(s) de formule M-C dans laquelle :
- M présente un ou plusieurs premiers métaux identiques ou différents choisis parmi Cu, Zn, Sn, Ge, Sb et Bi, de préférence Cu, Zn, Sn et Sb et
- C représente un ou plusieurs éléments chalcogénures identiques ou différents choisis parmi S, Se et Te,
**caractérisé en ce qu'**on réalise les étapes successives suivantes à température de 0°C à 50°C, de préférence de 20° à 40°C dans lesquelles :
a) on réalise une première solution d'au moins un précurseur de dit premier métal M, autre qu'un sel de chalcogénure C en solution dans un solvant consistant dans de l'acétonitrile pur ou en mélange avec de l'eau et/ou un alcool autre que le méthanol, de préférence de l'éthanol, et
b) on réalise une deuxième solution aqueuse, alcoolique ou hydro alcoolique d'au moins un précurseur de chalcogénure C consistant dans au moins un sel chacogénure de deuxième métal, autre qu'un premier métal M, l'alcool de ladite deuxième solution étant autre que le méthanol, de préférence de l'éthanol, et
c) on mélange à pression atmosphérique et température ambiante les 2 dites première et deuxième solutions de précurseurs jusqu'à obtenir, dans un laps de temps inférieur à une minute, une solution colloïdale brute comprenant des nanoparticules amorphes primaires de tailles inférieures à 30 nm, de préférence 3 à 20 nm, et
d) on sépare la partie solide de ladite solution colloïdale de l'étape c), de préférence par centrifugation pour obtenir un résidu solide après retrait du surnageant liquide, et
e) on rince le résidu solide obtenu à l'étape d) en y versant une solution aqueuse, alcoolique ou hydro alcoolique pour former une solution colloïdale, l'alcool de ladite solution colloïdale aqueuse, alcoolique ou hydro alcoolique étant autre que le méthanol, de préférence de l'éthanol, et
f) on sépare à nouveau la partie solide de ladite solution colloïdale de l'étape e), de préférence par centrifugation pour obtenir après retrait du surnageant liquide, un résidu solide rincé sous forme de pâte humide, et
g) on redisperse ladite pâte humide de l'étape f) dans un solvant de dispersion comprenant, de préférence consistant dans une solution aqueuse, alcoolique ou hydro alcoolique, l'alcool de ladite solution alcoolique ou hydro alcoolique étant le cas échéant un alcool autre que le méthanol.

2. Procédé selon la revendication 1, caractérisé à ce que l'étape g) on met en œuvre un dit solvant de dispersion consistant dans une solution aqueuse, alcoolique ou hydro alcoolique, l'alcool de ladite solution alcoolique ou hydro alcoolique étant un alcool autre que le méthanol présentant une température d'ébullition inférieure à la température d'ébullition de l'eau, de préférence de l'éthanol ou propanol, de préférence encore consistant en un mélange eau/éthanol.

3. Procédé de préparation selon la revendication 1 ou 2, **caractérisé en ce que** :
- à l'étape a), ledit sel de premier métal M est un halogénure, de préférence un chlorure, et
- à l'étape b), ledit sel chalcogénure de dit deuxième métal est un sel de métal alcalin ou alcalino-terreux, de préférence un sel de sodium ou potassium.

4. Procédé de préparation selon l'une des revendications précédentes, **caractérisé en ce que** M est un mélange ternaire de Cu, Zn et Sn, et C est S, et à l'étape c) on obtient des nanoparticules amorphes de Cu₂ZnSnS₄.

5. Procédé de préparation selon la revendication 3 ou 4, **caractérisé en ce que** :
- à l'étape a), on réalise une dite première solution contenant CuCI2, ZnCI2 et SnCl₄, et
- à l'étape b), on réalise une dite deuxième solution aqueuse de NaSH, de préférence à une concentration supérieure à 5 M, et
- à l'étape c), on obtient des nanoparticules amorphes de Cu₂ZnSnS₄

6. Procédé de préparation selon l'une des revendications 1 à 3, **caractérisé en ce que** M-C est choisi parmi SnS et Sb₂S₃.

## Patentansprüche

1. Verfahren zur Herstellung einer kolloidalen alkoholischen oder hydroalkoholischen wässrigen Lösung amorpher Nanopartikel aus (einem) Metallchalkogenid/en mit der Formel M-C, wobei:
- M ein oder mehrere identische oder unterschiedliche erste Metalle aufweist, die aus Cu, Zn, Sn, Ge, Sb und Bi, vorzugsweise Cu, Zn, Sn und Sb, ausgewählt werden, und
- C ein oder mehrere identische oder unterschiedliche Chalkogenidelemente darstellt, die aus S, Se und Te ausgewählt werden,
**dadurch gekennzeichnet, dass** die folgenden aufeinanderfolgenden Schritte bei einer Temperatur von 0 °C bis 50 °C, vorzugsweise von 20 °C bis 40 °C, ausgeführt werden, in denen:
a) eine erste Lösung mindestens eines Vorprodukts des ersten Metalls M, das sich von einem C-Chalkogenidsalz unterscheidet, in Lösung in einem Lösungsmittel ausgeführt wird, das aus Acetonitril in Reinform oder in Mischung mit Wasser und/oder einem Alkohol, der sich von Methanol unterscheidet, vorzugsweise Ethanol, besteht, und
b) eine zweite alkoholische oder hydroalkoholische wässrige Lösung mindestens eines C-Chalkogenidvorprodukts, das aus mindestens einem Chalkogenidsalz des zweiten Metalls besteht, das sich von einem ersten Metall M unterscheidet, ausgeführt wird, wobei der Alkohol der zweiten Lösung sich von Methanol unterscheidet und vorzugsweise Ethanol ist, und
c) die 2 sogenannten ersten und zweiten Lösungen von Vorprodukten bei Umgebungsdruck und Umgebungstemperatur gemischt werden, bis in einem Zeitraum von weniger als einer Minute eine kolloidale Rohlösung erhalten wird, die primäre amorphe Nanopartikel mit Größen von kleiner als 30 nm, vorzugsweise 3 bis 20 nm, umfasst, und
d) der feste Teil von der kolloidalen Lösung von Schritt c), vorzugsweise durch Zentrifugieren, getrennt wird, um nach Entfernung der oben schwimmenden Flüssigkeit einen festen Rest zu erhalten, und
e) der im Schritt d) erhaltene feste Rest gespült wird, indem eine alkoholische oder hydroalkoholische wässrige Lösung hineingeschüttet wird, um eine kolloidale Lösung zu bilden, wobei der Alkohol der alkoholischen oder hydroalkoholischen wässrigen kolloidalen Lösung sich von Methanol unterscheidet und vorzugsweise Ethanol ist, und
f) der feste Teil erneut von der kolloidalen Lösung von Schritt e) getrennt wird, vorzugsweise durch Zentrifugieren, um nach Entfernung der oben schwimmenden Flüssigkeit einen gespülten festen Rest in der Form einer feuchten Masse zu erhalten, und
g) die feuchte Masse von Schritt f) erneut in einem Dispersionslösungsmittel dispergiert wird, das vorzugsweise aus einer alkoholischen oder hydroalkoholischen wässrigen Lösung besteht, wobei der Alkohol der alkoholischen oder hydroalkoholischen Lösung gegebenenfalls ein Alkohol ist, der sich von Methanol unterscheidet.

2. Verfahren nach Anspruch 1, **dadurch gekennzeichnet, dass** im Schritt g) ein sogenanntes Dispersionslösungsmittel eingesetzt wird, das aus einer alkoholischen oder hydroalkoholischen wässrigen Lösung besteht, wobei der Alkohol der alkoholischen oder hydroalkoholischen Lösung ein Alkohol ist, der sich von Methanol unterscheidet, eine Siedetemperatur aufweist, die niedriger als die Siedetemperatur von Wasser ist, vorzugsweise Ethanol oder Propanol ist, vorzugsweise auch aus einer Wasser/Ethanol-Mischung besteht.

3. Herstellungsverfahren nach Anspruch 1 oder 2, **dadurch gekennzeichnet, dass**:
- im Schritt a) das Salz des ersten Metalls M ein Halogenid, vorzugsweise ein Chlorid, ist, und
- im Schritt b) das Chalkogenidsalz des zweiten Metalls ein Alkali- oder Erdalkalimetall, vorzugsweise ein Natrium- oder Kalisalz, ist.

4. Herstellungsverfahren nach einem der vorhergehenden Ansprüche, **dadurch gekennzeichnet, dass** M eine ternäre Mischung aus Cu, Zn und Sn ist und C S ist, und im Schritt c) amorphe Cu₂ZnSnS₄-Nanopartikel erhalten werden.

5. Herstellungsverfahren nach Anspruch 3 oder 4, **dadurch gekennzeichnet, dass**:
- im Schritt a) eine erste Lösung ausgeführt wird, die CuCl₂, ZnCl₂ und SnCl₄ enthält, und
- im Schritt b) eine zweite wässrige NaSH-Lösung, vorzugsweise bei einer Konzentration von höher als 5 M, ausgeführt wird, und
- im Schritt c) amorphe Cu₂ZnSnS₄-Nanopartikel erhalten werden.

6. Herstellungsverfahren nach einem der Ansprüche 1 bis 3, **dadurch gekennzeichnet, dass** M-C aus SnS und Sb₂S₃ ausgewählt wird.

## Claims

1. A process for preparing an aqueous, alcoholic or colloidal hydro-alcoholic solution of amorphous nanoparticles of metal chalcogenide(s) of formula M-C wherein:
- M has one or more identical or different first metals selected from Cu, Zn, Sn, Ge, Sb and Bi, preferably Cu, Zn, Sn and Sb, and
- C represents one or more identical or different chalcogenide elements selected from S, Se and Te,
**characterized in that** the following successive steps are carried out at a temperature of 0°C to 50°C, preferably of 20°C to 40°C, wherein:
a) a first solution of at least one precursor of said first metal M, other than a chalcogenide C salt, is prepared in solution in a solvent consisting of pure acetonitrile or in a mixture with water and/or an alcohol other than methanol, preferably ethanol, and
b) a second aqueous, alcoholic or hydro-alcoholic solution of at least one chalcogenide C precursor consisting of at least one chacogenide salt of a second metal, other than a first metal M, is prepared, the alcohol of said second solution being other than methanol, preferably ethanol, and
c) both of said first and second precursor solutions are mixed at atmospheric pressure and room temperature until a crude colloidal solution comprising primary amorphous nanoparticles of sizes of less than 30 nm, preferably 3 to 20 nm, is obtained within a period of less than one minute, and
d) the solid portion is separated from said colloidal solution of step c), preferably by centrifugation, to obtain a solid residue after removal of the liquid supernatant, and
e) the solid residue obtained in step d) is rinsed by pouring an aqueous, alcoholic or hydro-alcoholic solution into it to form a colloidal solution, the alcohol of said aqueous, alcoholic or hydro-alcoholic colloidal solution being other than methanol, preferably ethanol, and
f) the solid portion is separated again from said colloidal solution of step e), preferably by centrifugation, to obtain, after removal of the liquid supernatant, a rinsed solid residue in the form of a wet paste, and
g) said wet paste of step f) is redispersed in a dispersion solvent comprising, preferably consisting of an aqueous, alcoholic or hydro-alcoholic solution, the alcohol of said alcoholic or hydro-alcoholic solution being, if need be, an alcohol other than methanol.

2. The process as claimed in claim 1, **characterized in that** in step g) use is made of a so-called dispersion solvent consisting of an aqueous, alcoholic or hydro-alcoholic solution, the alcohol of said alcoholic or hydro-alcoholic solution being an alcohol other than methanol having a boiling point lower than the boiling point of water, preferably ethanol or propanol, preferably still consisting of a water/ethanol mixture.

3. The preparation process as claimed in claim 1 or 2, **characterized in that**:
- in step a), said salt of first metal M is a halide, preferably a chloride, and
- in step b), said chalcogenide salt of said second metal is an alkali or alkaline earth metal salt, preferably a sodium or potassium salt.

4. The preparation process as claimed in one of the preceding claims, **characterized in that** M is a ternary mixture of Cu, Zn and Sn, and C is S, and in step c) amorphous nanoparticles of Cu₂ZnSnS₄ are obtained.

5. The preparation process as claimed in claim 3 or 4, **characterized in that**:
- in step a), a so-called first solution containing CuCl₂, ZnCl₂ and SnCl₄ is prepared, and
- in step b), a so-called second aqueous NaSH solution is prepared, preferably at a concentration greater than 5 M, and
- in step c), amorphous nanoparticles of Cu₂ZnSnS₄ are obtained

6. The preparation process as claimed in one of claims 1 to 3, **characterized in that** M-C is selected from SnS and Sb₂S₃.
